# EUROPEAN PATENT APPLICATION

(11) **EP 2 657 981 A1**
(43) Date of publication of application: **30.10.2013**
(21) Application number: 11857750.1
(22) Date of filing: 27.12.2011
(51) Int. Cl.: H01L 31/04, H01L 31/042

(54) **PHOTOELECTRIC CONVERTER AND PHOTOELECTRIC CONVERSION MODULE**

(30) Priority: 31.01.2011 JP 2011018381
(71) Applicant: Sanyo Electric Co., Ltd., Osaka 570-8677 (JP)
(72) Inventor: NARITA, Tomoki, Chuo-ku, Osaka 540-6207 (JP); NAKAMURA, Yuya, Chuo-ku Osaka 540-6207 (JP)
(74) Representative: Klunker . Schmitt-Nilson . Hirsch
(86) International application number: PCT/JP2011/080165
(87) International publication number: WO 2012/105146

(57) **Abstract**

A photovoltaic device (11) is provided with: a photoelectric conversion unit (20) having a light-receiving surface and a rear surface, each having a textured structure formed thereon; a light-receiving-surface electrode (30) provided on the light-receiving surface of the photoelectric conversion unit (20); and a rear-surface electrode (40) provided on the rear surface of the photoelectric conversion unit (20). The rear-surface electrode (40) includes: a transparent conductive layer (41) layered on the rear surface of the photoelectric conversion unit (20) ; a metallic film (42) layered on substantially the entire surface of the transparent conductive layer (41), and formed thinly so as to contain surface unevenness reflecting the textured structure; and a projecting electrode (43) formed on the metallic film (42) and having a thickness greater than or equal to the surface unevenness height of the metallic film (42).

## Description

### TECHNICAL FIELD

The present invention relates to a photovoltaic device and a photovoltaic module.

### BACKGROUND ART

Patent Document 1 discloses a photovoltaic device comprising a photoelectric conversion unit, a light receiving surface electrode provided on a light receiving surface of the photoelectric conversion unit, and a rear surface electrode provided on a rear surface of the photoelectric conversion unit. In this photovoltaic device, each of the light receiving surface electrode and the rear surface electrode comprises a plurality of finger electrode portions and a plurality of bus bar electrode portions electrically connected to the plurality of finger electrode portions.

### PRIOR ART LITERATURE

### PATENT DOCUMENTS

Patent Document 1: JP 2009-290234 A

### SUMMARY OF THE INVENTION

### PROBLEMS TO BE SOLVED BY THE INVENTION

In a photovoltaic device such as a solar cell, transmittance of light in the infrared region is a matter of concern. In addition, along with progresses in reduction of thickness of the photoelectric conversion unit, transmittance of light in other ranges is also increasingly a matter of concern. In this situation, it is desired to enhance light utilization efficiency and to thereby further increase photoelectric conversion efficiency.

Meanwhile, even when high photoelectric conversion efficiency is achieved, unless a photovoltaic device is modularized in a manner that enables successful extraction of electric power generated in the photovoltaic device, full use of the high photoelectric conversion efficiency cannot be made. A photovoltaic module comprises a plurality of photovoltaic devices, and wiring members electrically connected to the respective photovoltaic devices. In a photovoltaic module, as poor electrical connection between the photovoltaic devices and the wiring members results in large resistance loss, it is important to maintain favorable connection between those two components.

### MEANS FOR SOLVING THE PROBLEMS

A photovoltaic device according to the present invention comprises a photoelectric conversion unit having a light receiving surface and a rear surface each having a textured structure formed thereon, a light receiving surface electrode provided on the light receiving surface of the photoelectric conversion unit, and a rear surface electrode provided on the rear surface of the photoelectric conversion unit. The rear surface electrode includes a transparent conductive layer laminated on the rear surface of the photoelectric conversion unit, a metal layer laminated over substantially an entire surface of the transparent conductive layer and having surface unevenness reflecting the textured structure, and a projecting electrode formed on the metal layer and having a thickness greater than a height of the surface unevenness of the metal layer.

A photovoltaic module according to the present invention comprises a photovoltaic device, and a wiring member electrically connected to the photovoltaic device. The photovoltaic device comprises a photoelectric conversion unit, a light receiving surface electrode provided on a light receiving surface of the photoelectric conversion unit, and a rear surface electrode provided on a rear surface of the photoelectric conversion unit. The rear surface electrode includes a transparent conductive layer laminated on the rear surface of the photoelectric conversion unit, a metal layer laminated over substantially an entire surface of the transparent conductive layer, and a projecting electrode formed on the metal layer. The wiring member is electrically connected to the projecting electrode via an adhesive, and is also directly bonded to the metal layer via the adhesive in at least part of a periphery of the projecting electrode.

### ADVANTAGES OF THE INVENTION

According to the photovoltaic device of the present invention, there is provided a photovoltaic device that attains improved photoelectric conversion efficiency and with which a highly reliable module can be constructed.
Further, according to the photovoltaic module of the present invention, there is provided a photovoltaic module having improved photoelectric conversion efficiency and high reliability.

### BRIEF DESCRIPTION OF THE DRAWINGS

FIG. 1 is a cross-sectional view schematically showing a photovoltaic module according to an embodiment of the present invention.
FIG. 2 is a view of a photovoltaic device according to an embodiment of the present invention, as seen from its light receiving surface side.
FIG. 3 is a view of the photovoltaic device according to the embodiment of the present invention, as seen from its rear surface side.
FIG. 4 is a view schematically showing a cross-section taken along line B-B in FIGs. 2 and 3.
FIG. 5 is a cross-sectional view schematically showing a projecting electrode and its nearby portion in a photovoltaic module according to an embodiment of the present invention.
FIG. 6 is a view showing how a wiring member is connected to the projecting electrode of FIG. 5.
FIG. 7 is a view showing a variant example of the connection structure between the wiring member and the projecting electrode.
FIG. 8 is a view showing a variant example of the projecting electrode.
FIG. 9 is view showing another variant example of the projecting electrode.

### EMBODIMENTS OF THE INVENTION

Embodiments of the present invention are described below in detail with reference to the drawings.
The following embodiments are given by way of example only, and the present invention is not limited to those embodiments. Further, the drawings referred to in the description of the embodiments provide schematic views only. For example, dimensional ratios of the articles shown in the drawings may differ from the dimensional ratios of the actual articles. Specific dimensional ratios and the like of the articles should be determined in consideration of the following description.

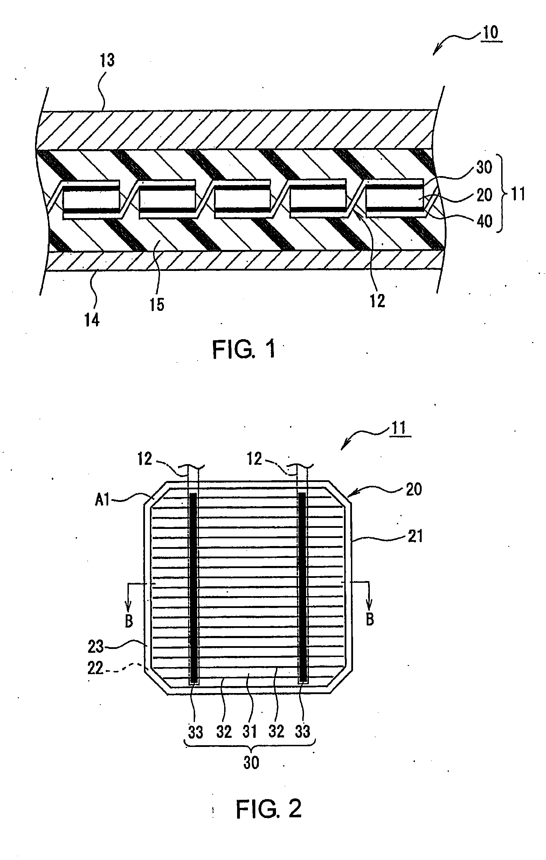

First, a schematic configuration of a photovoltaic module 10 is described with reference to FIG. 1.

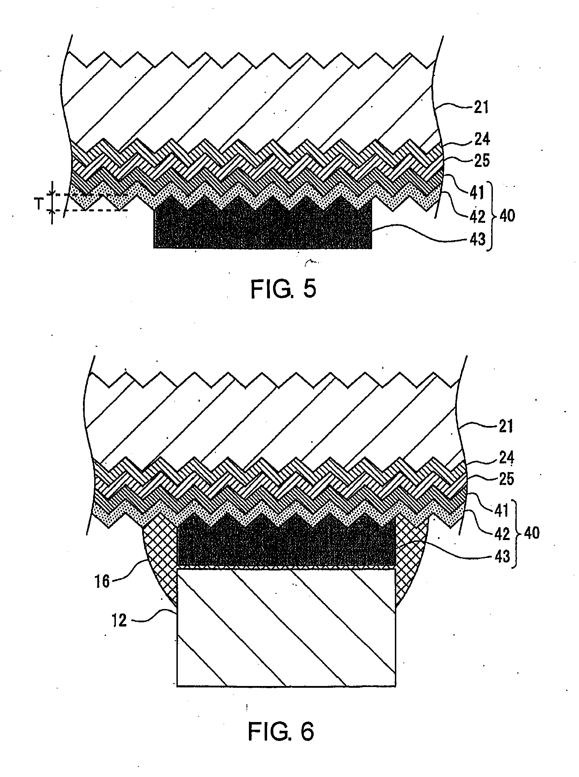

FIG. 1 is a cross-sectional view schematically showing part of the photovoltaic module 10.
The photovoltaic module 10 comprises a plurality of photovoltaic devices 11, and wiring members 12 connected to the respective photovoltaic devices 11. Further, the photovoltaic module 10 preferably includes a first protective member 13 for protecting the light receiving surface side of the photovoltaic devices 11, and a second protective member 14 for protecting the rear surface side of the photovoltaic devices 11. Furthermore, a sealant 15 is filled between the first protective member 13 and the second protective member 14. The photovoltaic devices 11 and the wiring members 12 can be connected to each other using an adhesive 16 (see FIG. 6 explained later).

Here, the "light receiving surface" denotes the main surface through which light enters from outside of the photovoltaic module 10 (or photovoltaic device 11). For example, among all light entering into the photovoltaic module 10 (or photovoltaic device 11), more than 50% to 100% of the light enters from the light receiving surface side. Further, the "rear surface" denotes the surface opposite the light receiving surface.

Each photovoltaic device 11 comprises a photoelectric conversion unit 20 that generates carriers (i.e., electrons and positive holes) upon receiving light such as solar light, a light receiving surface electrode 30 provided on the light receiving surface of the photoelectric conversion unit 20, and a rear surface electrode 40 provided on the rear surface of the photoelectric conversion unit 20. In the photovoltaic device 11, carriers generated in the photoelectric conversion unit 20 are collected by the light receiving surface electrode 30 and the rear surface electrode 40. Further, the wiring members 12 are electrically connected to the light receiving surface electrode 30 and the rear surface electrode 40, and, via the wiring members 12, the carriers are extracted to the outside of the module as electric energy.

The plurality of photovoltaic devices 11 may be arranged so that their respective light receiving surfaces are aligned in the same plane. FIG. 1 shows an example in which the photovoltaic devices 11 are arranged at equal intervals, and a single wiring member 12 connects adjacent photovoltaic devices 11 with each other. For example, a single wiring member 12 is connected to the light receiving surface electrode 30 of a first photovoltaic device 11 and to the rear surface electrode 40 of a second photovoltaic device 11. In other words, the wiring member 12 is bent along the module thickness direction at a position between the adjacent photovoltaic devices 11, and connects the adjacent photovoltaic devices 11 in series. The wiring member 12 is a conductive member having thin linear form, and may have a rectangular cross-section. The wiring member 12 has a length that enables connection of adjacent photovoltaic devices 11 with each other, and preferably has a uniform width (of 1 to 2 mm, for example) over the entire length thereof.

The first protective member 13 is disposed on the light receiving surface side of the photovoltaic device 11, and may be formed from glass, transparent resin, or the like. The second protective member 14 is disposed on the rear surface side of the photovoltaic device 11, and the photovoltaic device 11 is held between the first and second protective members 13, 14. In one example, the second protective member 14 is formed from a resin film having therein an interposed metal foil such as an aluminum foil. Further, the sealant 15, which is filled between the first protective member 13 and the second protective member 14 to thereby cover the periphery of the photovoltaic device 11, may be formed from a transparent resin such as ethylene-vinyl acetate (EVA) copolymer or polyvinyl butyral (PVB).

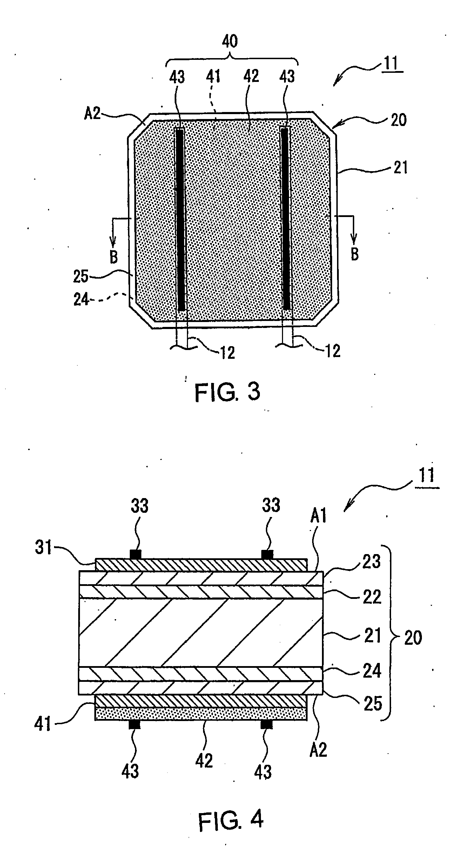

Next, the configuration of the photovoltaic devices 11 is described in detail with reference to FIGs. 2 to 4. FIG. 2 is a view of a photovoltaic device 11 as seen from its light receiving surface side. FIG. 3 is a view of the photovoltaic device 11 as seen from its rear surface side. FIG. 4 is a cross-sectional view taken along line B-B in FIGs. 2 and 3 (but the textured structure is not shown).

As shown in FIGs. 2 and 3, the photovoltaic device 11 comprises the photoelectric conversion unit 20, the light receiving surface electrode 30, and the rear surface electrode 40. For example, the photoelectric conversion unit 20 comprises an n-type monocrystalline silicon substrate 21, which is a substantially square crystalline semiconductor substrate. The light receiving surface electrode 30 includes a transparent conductive layer 31, finger electrode portions 32, and bus bar electrode portions 33. The rear surface electrode 40 includes a transparent conductive layer 41, a metal layer 42, and projecting electrodes 43. When the photovoltaic module 10 is constructed from the photovoltaic devices 11, the wiring members 12 (shown in dash-dot lines) are connected to the respective bus bar electrode portions 33 of the light receiving surface electrode 30 and to the respective projecting electrodes 43 of the rear surface electrode 40.

As shown in FIGs. 2 and 4, the photoelectric conversion unit 20 includes a p-type amorphous silicon layer 23 laminated over the light receiving surface of the n-type monocrystalline silicon substrate 21, with an i-type amorphous silicon layer 22 disposed therebetween. As shown in FIGs. 3 and 4, the photoelectric conversion unit 20 further includes an n-type amorphous silicon layer 25 laminated over the rear surface of the n-type monocrystalline silicon substrate 21, with an i-type amorphous silicon layer 24 disposed therebetween. In other words, the photoelectric conversion unit 20 has a structure in which amorphous semiconductor thin films are laminated on both surfaces of a crystalline semiconductor substrate. The present embodiment shows, as an example, a specific lamination structure in which the p-type amorphous silicon layer 23, the i-type amorphous silicon layer 22, the n-type monocrystalline silicon substrate 21, the i-type amorphous silicon layer 24, and the n-type amorphous silicon layer 25 are layered in that order. In this stacked structure, the side of the p-type amorphous silicon layer 23 corresponds to the light receiving surface side.

The i-type amorphous silicon layers 22, 24 may be laminated while leaving edge regions of the light receiving surface and rear surface uncovered. Each of the i-type amorphous silicon layers 22, 24 is an intrinsic amorphous silicon thin film having a lower concentration of carrier-generating dopant as compared to the p-type amorphous silicon layer 23 and the n-type amorphous silicon layer 25. The i-type amorphous silicon layers 22, 24 have the same composition, for example. Although not shown in FIGs. 2 and 4, each of the light receiving surface and rear surface of the n-type monocrystalline silicon substrate 21 includes a textured structure. Here, the "textured structure" denotes a structure comprising dips and bumps for suppressing surface reflection and increasing the amount of light absorption by the photoelectric converter 20. The thickness (or the length along the direction of film lamination) of the photoelectric converter 20 is several hundred µm, and this thickness mostly corresponds to the thickness of the n-type monocrystalline silicon substrate 21. Of this thickness of the substrate 21, the height of unevenness of the textured structure is several µm. Meanwhile, the thickness of the amorphous silicon layers is within the range from several nm to several tens of nm. In an exemplary embodiment, as the height of unevenness of the textured structure is several µm, the textured structure is reflected in the light receiving surface and rear surface of each amorphous silicon layer.

The photoelectric converter 20 can be manufactured according to the following method, for example. First, a clean n-type monocrystalline silicon substrate 21 is placed inside a vacuum chamber, and the i-type amorphous silicon layer 22 is laminated on this substrate by plasma CVD (chemical vapor deposition), for example. Next, the p-type amorphous silicon layer 23 is laminated over the i-type amorphous silicon layer 22. In the present embodiment, the side of the n-type monocrystalline silicon substrate 21 on which the p-type amorphous silicon layer 23 is laminated serves as the light receiving surface. Meanwhile, similarly, on the rear surface of the n-type monocrystalline silicon substrate 21, the i-type amorphous silicon layer 24 and the n-type amorphous silicon layer 25 are sequentially laminated by plasma CVD, for example. In the step of laminating the i-type amorphous silicon layer 24, silane gas (SiH₄) is used as the raw material gas, for example. Further, for example, in the step of laminating the n-type amorphous silicon layer 25, silane (SiH₄), hydrogen (H₂), and phosphine (PH₃) are used as the raw material gases, while PH₃ is replaced with diborane (B₂H₆) in the step of laminating the p-type amorphous silicon layer 23.

On the light receiving surface of the p-type amorphous silicon layer 23, the transparent conductive layer 31 constituting the light receiving surface electrode 30 is laminated. Further, the finger electrode portions 32 and bus bar electrode portions 33 that collect electric power generated in the photoelectric converter 20 are formed over the transparent conductive layer 31. Meanwhile, on the rear surface of the n-type amorphous silicon layer 25, the transparent conductive layer 41 constituting the rear surface electrode 40 is laminated. Further, the metal layer 42 for collecting electric power generated in the photoelectric converter 20 is formed over the transparent conductive layer 41. On the metal layer 42, the projecting electrodes 43 having protruded form and serving as connectors to the wiring members 12 are provided.

The transparent conductive layer 31 may, for example, be a thin film (TCO film) containing at least one of metal oxides such as indium oxide (In₂O₃), zinc oxide (ZnO), tin oxide (SnO₂), and titanium oxide (TiO₂) having polycrystalline structure, and the transparent conductive layer 31 functions as a light-transmitting electrode portion. The above-noted metal oxides may be doped with a dopant such as tin (Sn), zinc (Zn), tungsten (W), antimony (Sb), titanium (Ti), aluminum (Al), cerium (Ce), or gallium (Ga). The dopant concentration can be within the range of 0 to 20wt%. The thickness of the transparent conductive layer 31 is, for example, within the approximate range of 50 nm to 200 nm. Preferably, the transparent conductive layer 31 is laminated on the light receiving surface of the p-type amorphous silicon layer 23 over the entire surface region except for the edge region (hereinafter referred to as "edge region A1"). The edge region Al in which the transparent conductive layer 31 is not laminated is, for example, a surface region of the light receiving surface of the p-type amorphous silicon layer 23 that extends from the edges of the light receiving surface by a width of approximately 1 mm to 2 mm, and is preferably annularly provided around the light receiving surface. The transparent conductive layer 31 can be laminated by, for example, a sputtering method using a mask that covers the edge region Al (the transparent conductive layer 41 can also be formed in a similar manner).

The finger electrode portions 32 and the bus bar electrode portions 33 are electrically connected to each other, and are both formed over the transparent conductive layer 31. Specifically, in the light receiving surface electrode 30, carriers transferred from the p-type amorphous silicon layer 23 via the transparent conductive layer 31 are collected by the finger electrode portions 32 and the bus bar electrode portions 33. When modularizing, the wiring members 12 are electrically connected to the bus bar electrode portions 33. The finger electrode portions 32 and the bus bar electrode portions 33 are, for example, thin linear electrode parts formed by screen printing, in a desired pattern on the transparent conductive layer 31, with a conductive paste composed of a binder resin containing conductive particles such as silver (Ag) dispersed therein. Instead of using screen printing, the respective electrode parts may be formed using various sputtering methods, deposition methods, and plating methods.

The finger electrode portions 32 are, for example, a metal layer formed on the light receiving surface in the shape of bands, and are arranged so as to be able to collect electric power uniformly from the entire photoelectric conversion unit 20. The finger electrode portions 32 are preferably arranged in parallel to each other while being spaced apart by a predetermined interval (for example, the width is 100 µm and the interval is 2 mm).

The bus bar electrode portions 33 serve to further collect the electric power that has been collected by the finger electrode portions 32. The bus bar electrode portions 33 are, for example, a metal layer formed on the light receiving surface in the shape of bands arranged orthogonally to the finger electrode portions 32, and are electrically connected to the finger electrode portions 32. The bus bar electrode portions 33 can be, for example, arranged in parallel to each other while being spaced apart by a predetermined interval. Here, compared to the finger electrode portions 32, the bus bar electrode portions 33 are preferably provided in a smaller number and configured to have a broader line width (for example, the width is 1.5 mm and the number of bands is two). Further, since the bus bar electrode portions 33 are to be connected with the wiring members 12, the bus bar electrode portions 33 are preferably configured to have a thickness larger than the finger electrode portions 32. The finger electrode portions 32 are formed to have a thickness of approximately 30 µm to 80 µm, for example, in order to prevent increase in resistance due to concentration of carriers. Accordingly, the bus bar electrode portions 33 have a thickness larger than or equal to 30 µm, for example, and preferably a thickness larger than or equal to 50 µm (for example, in the range of 50 µm to 100 µm).

The shapes of the finger electrode portions 32 and the bus bar electrode portions 33 are not limited to those described herein, and may have various forms such as a zigzag shape, for example.

The transparent conductive layer 41 is, similar to the transparent electrode film 31, composed of a material such as ITO, ZnO, or SnO₂, and functions as a light-transmitting electrode sections. Further, the transparent conductive layer 41 has the function of increasing reflectance by a cooperative effect exerted together with the metal layer 42, and the function of preventing direct contact between the photoelectric conversion unit 20 and the metal layer 42. The thickness of the transparent conductive layer 41 is preferably within the approximate range of 50 nm to 200 nm, for example, and the above-noted textured structure is also reflected in the rear surface of the transparent conductive layer 41.

The transparent conductive layer 41 is laminated on the rear surface of the n-type amorphous silicon layer 25 over the entire surface region except for the edge region (hereinafter referred to as "edge region A2"). The edge region A2 in which the transparent conductive layer 41 is not laminated is, for example, a surface region of the rear surface of the n-type amorphous silicon layer 25 that extends from the edges of the rear surface by a width of approximately 1 mm to 2 mm, and is preferably annularly provided around the rear surface.

The metal layer 42 is a thin film composed of a metal material having high light reflectance and high conductivity. Specifically, the metal layer 42 is preferably composed of a material having high reflectance with respect to light in the infrared region having a wavelength in the approximate range of 800 nm to 1200 nm. Preferably, the reflectance of the metal layer 42 is higher than the reflectance of the transparent conductive layer 41 at least with respect to light in the infrared region.

The metal material constituting the metal layer 42 can be, for example, a metal such as silver (Ag), aluminum (Al), titanium (Ti), rhodium (Rh), copper (Cu), gold (Au), platinum (Pt), nickel (Ni), or chromium (Cr), or an alloy containing one or more of these metals. Among the above-listed example materials, Ag, Al, Ti, Rh, Cu, Au, and an alloy containing one or more of these metals are preferable as the metal material. Further, Ag, Al, Ti, and an alloy containing one or more of these metals are more preferable, and Ag and an alloy containing Ag are particularly preferable.

The metal layer 42 reflects light transmitted through the photoelectric conversion unit 20 toward the light receiving surface side, and collects carriers transferred from the n-type amorphous silicon layer 25 via the transparent conductive layer 41. The thickness of the metal layer 42 is described in detail as follows. The metal layer 42 desirably has a thickness that is sufficiently large for disabling light transmission and enabling sufficient collection of carriers by the projecting electrodes 43. Here, although the light receiving surface electrode 30 is configured by forming the finger electrode portions 32 and the bus bar electrode portions 33 while exposing the transparent conductive layer 31 as shown in FIG. 2, the metal layer 42 is formed covering substantially the entire surface of the transparent conductive layer 41 as shown in FIG. 3. Accordingly, the metal layer 42 has a larger area compared to the light receiving surface electrode 30. For this reason, if the thickness of the light receiving surface electrode 30 and the thickness of the metal layer 42 are closely similar to each other, the photoelectric conversion unit 20 would become deflected in accordance with the difference between the amount of metal material used for the light receiving surface electrode 30 and that used for the metal layer 42. To address this problem, in the photovoltaic device 11, the metal layer 42 is formed thinner than the light receiving surface electrode 30. As a result, difference in the amount of metal material between the light receiving surface electrode 30 and the metal layer 42 is reduced, and deflection of the photoelectric conversion unit 20 is suppressed.

In order to suppress deflection of the photoelectric conversion unit 20, preferably the metal layer 42 is configured to have a thickness that is sufficiently reduced for reflecting the above-noted textured structure in its rear surface. For example, the thickness of the metal layer 42 is preferably within the approximate range of 0.1 µm to 5 µm. By configuring such that the textured structure is reflected in the rear surface of the metal layer 42, it is also possible to attain favorable adhesion between the metal layer 42 and the projecting electrodes 43. Since the metal layer 42 is formed covering substantially the entire surface of the transparent conductive layer 41 as explained above, such reduction of the thickness of the metal layer 20 does not result in increase in resistance, and does not impart influences on characteristics such as the photoelectric conversion efficiency.

The metal layer 42 may be configured as a laminate of a plurality of films made of the above-described metal materials. For example, the metal layer 42 may be a laminate of an Ag film and an Al film. In this case, it is preferable to position the Ag film on the side of the transparent conductive layer 41. Further, it is also possible to employ an Ag/Al/Ag laminate formed by laminating Ag films on both sides of an Al film, or an Ag/Cu/Ag laminate in which a different metal layer (such as a Cu film) is provided instead of the Al film.

The metal layer 42 is laminated so as to substantially entirely cover the transparent conductive layer 41, and more preferably, the metal layer 42 is laminated so as to entirely cover the transparent conductive layer 41. Here, "substantially entirely covering the transparent conductive layer 41" denotes a state in which it can be recognized that the transparent conductive layer 41 is essentially entirely covered, and this includes a state in which the metal layer 42 laminated on the transparent conductive layer 41 is partially absent. A specific example is a state in which the metal layer 42 is covering 95% or more of the transparent conductive layer 41.

Preferably, the metal layer 42 is laminated such that, in at least part of the edge region of the transparent conductive layer 41, the metal layer 42 is prevented from extending beyond the transparent conductive layer 41 so as to not cover the photoelectric conversion unit 20 (or n-type amorphous silicon layer 25). By laminating the metal layer 42 in this manner, it is possible to further minimize generation of defect level that may occur due to diffusion of metal atoms in the n-type amorphous silicon layer 25. More preferably, a region in which the metal layer 42 is absent is annularly provided along the entire perimeter of the edge region of the transparent conductive layer 41. This edge region preferably extends from the edge of the transparent conductive layer 41 by a width in the range of 1 nm to 5 mm, for example, and this can be confirmed in a cross-section observation using a scanning electron microscope (SEM) or a transmission electron microscope (TEM) (in the case of a large width, an optical microscope or the like can also be used).

The metal layer 42 can be laminated by, for example, a sputtering method using a mask that covers the edge region A2 of the n-type amorphous silicon layer 25 or the edge region of the transparent conductive layer 41.

The projecting electrodes 43 are electrodes in the shape of projections formed protruding in the direction of thickness of the photoelectric conversion unit 20. The projecting electrodes 43 are used for electrically connecting the wiring members 12 when modularizing a plurality of photovoltaic devices 11. In a manner similar to the bus bar electrode portions 33, the projecting electrodes 43 may be formed by, for example, screen printing a conductive paste in a desired pattern on the metal layer 42, so as to form projecting shapes to which the wiring members 12 are electrically connectable.

The projecting electrodes 43 are, for example, a metal layer formed on the metal layer 42 in the shape of bands, and may be arranged parallel to each other while being spaced apart by a predetermined interval. Further, preferably, the projecting electrodes 43 are arranged along the same direction as the bus bar electrode portions 33 and provided in the same number as the bus bar electrode portions 33 (for example, two). As described above, the wiring members 12 connected to the projecting electrodes 43 are connected to the bus bar electrode portions 33 of an adjacent photovoltaic device 11. Accordingly, by configuring such that the bus bar electrode portions 33 and the projecting electrodes 43 are provided in the same number and formed along the same direction, connection between the photovoltaic devices 11 and the wiring members 12 is facilitated.

Since the projecting electrodes 43 are formed on the metal layer 42 that is laminated covering substantially the entire surface of the transparent conductive layer 41, the projecting electrodes 43 are not subjected to limitation in thickness by the finger electrode portions 32 as are the bus bar electrode portions 33. The thickness of the projecting electrodes 43 can therefore be made smaller than the thickness of the bus bar electrode portions 33.

Next, with reference to FIGs. 5 to 9, a configuration of a projecting electrode 43 and a connection structure between the photovoltaic device 11 (or projecting electrode 43) and a wiring member 12 in the photovoltaic module 10 are described in further detail. FIG. 5 is a cross-sectional view schematically showing a projecting electrode 43 and its nearby portion, the view being obtained by cutting the projecting electrode 43 along the width direction. FIG. 6 is a view showing how a wiring member 12 is connected to the projecting electrode 43 of FIG. 5.

As shown in FIG. 5, the light receiving surface and rear surface of the photoelectric conversion unit 20 are each provided with a textured structure. The metal layer 42 is formed sufficiently thin so as to include surface unevenness in accordance with the textured structure.

To achieve favorable electrical connection with a wiring member 12, each projecting electrode 43 is formed to have a height that is at least sufficient for filling in the surface unevenness of the metal layer 42. This can be attained by forming the projecting electrode 43 at a thickness larger than or equal to the surface unevenness height (T) of the metal layer 42.

Here, the "surface unevenness of the metal layer 42" denotes dips and bumps formed in the metal layer 42 in the thickness direction. The "surface unevenness height (T)" denotes the distance along the thickness direction from the bottom of a dip to the top of a bump. In the present embodiment, the surface unevenness is formed due to the textured structure of the n-type monocrystalline silicon substrate 21. For example, the surface unevenness of the metal layer 42 formed due to the textured structure has the surface unevenness height (T) in the range of 1 µm to 10 µm, and is formed continuously over the entire rear surface of the metal layer 42. The thickness of each projecting electrodes 43 is preferably larger than or equal to the average value of the surface unevenness height (T) obtained at the position where the projecting electrode 43 is formed, and is more preferably larger than or equal to the maximum value of T. Here, the T value of the surface unevenness of the metal layer 42 formed due to the textured structure is substantially uniform (i.e., average value ≈ maximum value), and may be approximately 5 µm, for example.

On the other hand, the thickness of the projecting electrodes 43 is preferably made adequately small to enable the wiring members 12 to be sufficiently bonded to the metal layer 42 via the adhesive 16. For example, the thickness of the projecting electrodes 43 is preferably equal to 1.0 to 3.0 times the value of T, more preferably 1.1 to 2.5 times the value of T, and particularly preferably 1.2 to 2.0 times the value of T. Specifically, the thickness of the projecting electrodes 43 is preferably less than or equal to 20 µm, more preferably less than or equal to 15 µm, and particularly preferably less than or equal to 10 µm.

The width of the projecting electrodes 43 is not particularly limited, and may be equal to the width of the bus bar electrode portions 22 or the width of the wiring members 12, for example. The width of the projecting electrodes 43 is, for example, in the approximate range of 0.5 mm to 2 mm, and may be smaller than or equal to the width of the wiring members 12 (for example, in the range of 0.5 mm to 1 mm). The thickness and width of the projecting electrodes 43 can be confirmed using an optical microscope or a contact-type film thickness gauge, for example. Such confirmation can also be made in a cross-section observation using an SEM.

As shown in FIG. 6, a wiring member 12 is electrically connected to a projecting electrode 43 of the rear surface electrode 40 via the adhesive 16. The thin film layer of the adhesive 16 present between the wiring member 12 and the projecting electrode 43 has a thickness in the approximate range of several nm to several hundred nm, for example (this can be confirmed in a cross-section observation using an SEM or TEM, for example). In the example shown in FIG. 6, the wiring member 12 having a rectangular cross-section is connected to the projecting electrode 43 via the thin film layer of the adhesive 16. This connection is achieved by, for example, pressing the wiring member 12 against the projecting electrode 43 to which the adhesive 16 has been applied, to thereby form a bonding. During this process, part of the adhesive 16 is pushed out from between the wiring member 12 and the projecting electrode 43 and adheres to side surfaces of the projecting electrode 43 and the wiring member 12, so as to coat at least part of each of those side surfaces. Here, the "side surfaces" of the projecting electrode 43 and the wiring member 12 denote surfaces of those components that extend along the thickness direction.

As the adhesive 16, it is possible to use, for example, a thermosetting adhesive such as epoxy resin, or a two-part curing adhesive obtained by mixing a curing agent into epoxy resin, acrylic resin, urethane resin, or the like. The adhesive 16 can contain conductive particles. When an adhesive 16 that does not contain conductive particles is used, it is possible to employ a wiring member 12 having a soft conductive surface layer made of tin (Sn) or the like, and form the connection by causing a part of the projecting electrode 43 to dent into this conductive surface layer.

In the example shown in FIG. 6, the width of the wiring member 12 and the width of the projecting electrode 43 are substantially equal, and the connection is formed so that the edges of these two components in the width direction are substantially aligned with each other. Further, the projecting electrode 43 has a linearly extended shape, and the wiring member 12 is, for example, connected over the entire length of the projecting electrode 43. At its portion to be connected to the projecting electrode 43, the wiring member 12 has a linearly extended shape similar to the projecting electrode 43.

The wiring member 12 is preferably directly bonded to the metal layer 42 via the adhesive 16 in at least part of the periphery of the projecting electrode 43. For example, part of the adhesive 16 is pushed out from between the projecting electrode 43 and the wiring member 12, and the pushed-out adhesive 16 adheres to the metal layer 42 in at least part of the periphery of the projecting electrode 43. Specifically, as described above, the pushed-out adhesive 16 adheres to the side surfaces of the projecting electrode 43 and the wiring member 12, so as to coat at least part of each of those side surfaces. Further, in one example, the pushed-out adhesive 16 covers the entire side surface of the projecting electrode 43 and reaches the metal layer 42. In other words, by pressing the wiring member 12 against the projecting electrode 43, part of the adhesive 16 is pushed out from between the projecting electrode 43 and the wiring member 12. The pushed-out adhesive 16 coats the side surfaces of the projecting electrode 43 and the wiring member 12, and extends beyond the thickness of the projecting electrode 43 to reach the metal layer 42. The adhesive 16 hardens in a state of being extended continuously from the side surface of the wiring member 12 to the metal layer 42.

In this way, the wiring member 12 is connected to the projecting electrode 43 via the adhesive 16, and is also directly bonded to the metal layer 42 via the pushed-out adhesive 16 in at least part of the periphery of the projecting electrode 43. Formation of this connection structure is facilitated by reducing the thickness of the projecting electrode 43 positioned between the wiring member 12 and the metal layer 42. Moreover, along with reduction in thickness of the projecting electrode 43, the area of the side surface of the wiring member 12 that is coated by the adhesive 16 becomes increased. For example, by configuring the projecting electrode 43 to have a thickness of less than or equal to 20 µm, the adhesive 16 can be hardened in a state of being extended continuously from the side surface of the wiring member 12 to the metal layer 42, without involving an excessive use of the adhesive 16.

The wiring member 12 is preferably directly bonded to the metal layer 42 via the adhesive 16 on at least one side, in the width direction, of the projecting electrode 43, and more preferably directly bonded to the metal layer 42 on both sides of the projecting electrode 43 in the width direction. In this regard, the adhesive 16 preferably adheres to the side surface of the wiring member 12 on at least one side in the width direction. More preferably, the adhesive 16 adheres to the side surface of the wiring member 12 on both sides in the width direction and coats at least part of the side surface, so that the side surface of the wiring member 12 and the metal layer 42 are directly bonded to each other via the adhesive 16. In addition, the wiring member 12 is preferably directly bonded to the metal layer 42 via the adhesive 16 along the entire length of the projecting electrode 43 in the lengthwise direction. Further, the wiring member 12 and the metal layer 42 may be bonded to each other via the adhesive 16 on both sides, in the lengthwise direction, of the projecting electrode 43 provided on the metal layer 42.

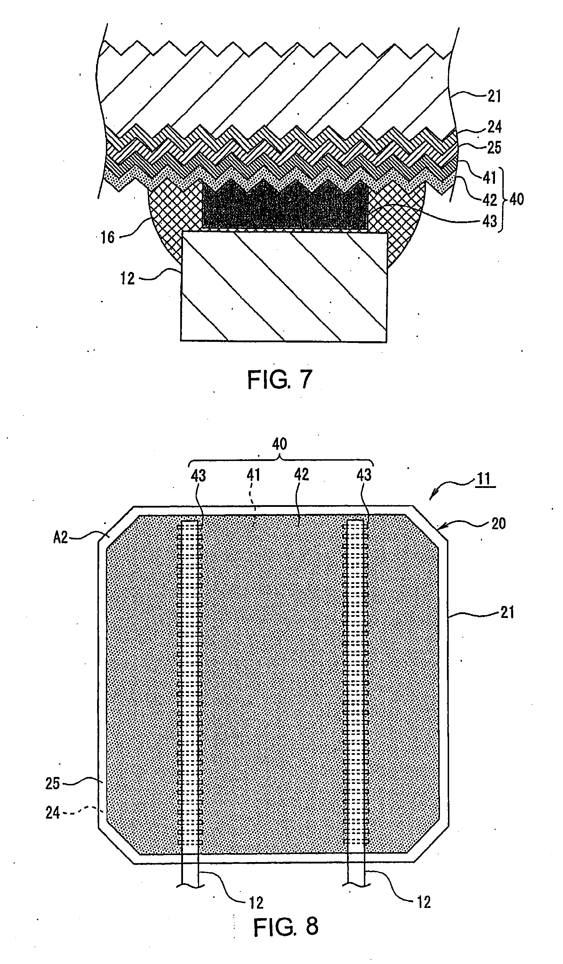

As shown in FIG. 7, the wiring member 12 may have a width larger than that of the projecting electrode 43, and the wiring member 12 can be connected to the projecting electrode 43 while in a state of being protruded from both sides of the projecting electrode 43 in the width direction. This connection structure can be formed by, for example, reducing the width of the projecting electrode 43 while maintaining the width of the wiring member 12. According to this connection structure, the bonding area between the wiring member 12 and the metal layer 42 can be increased on both sides, along the width direction, of the projecting electrode 43 provided on the metal layer 42. In this case too, preferably the adhesive 16 coats at least part of the side surface of the wiring member 12 on both sides in the width direction so that the side surface of the wiring member 12 and the metal layer 42 are directly bonded to each other via the adhesive 16.

As shown in FIG. 8, the projecting electrodes 43 may be disposed in an arrangement of a plurality of arrays while being spaced apart from each other. For example, the plurality of projecting electrodes 43 are formed in a linear arrangement. In this case, the wiring members 12 are preferably directly bonded to the metal layer 42 via the adhesive 16 at the gaps between adjacent projecting electrodes 43. Preferably, the projecting electrodes 43 are formed so that the density of formation is non-uniform; namely, the density of the projecting electrodes 43 at the end portions of the wiring members 12 being higher than the density at the center portions. While the end portions of the wiring members 12 tend to be susceptible to peeling when deflection is generated in the photovoltaic device 11, according to this configuration, bonding force is increased at the end portions of the wiring members 12, thereby enabling to prevent detachment of the wiring members 12 from the photovoltaic device 11. Further, metal material costs can be reduced at the center portions.

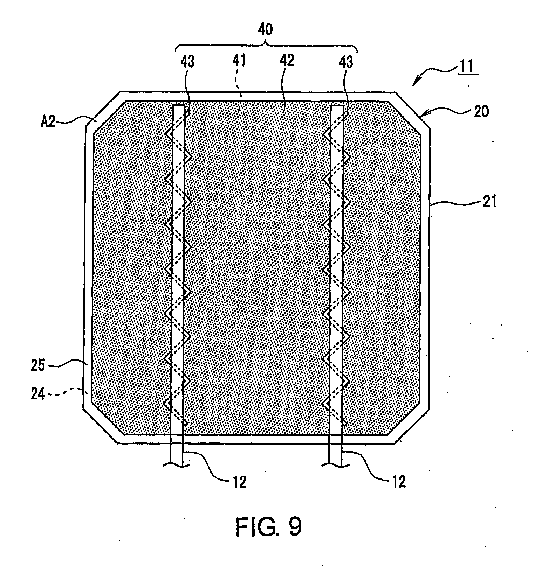

As shown in FIG. 9, the projecting electrodes 43 may be formed in a zigzag pattern. While, in the example shown in FIG. 9, each projecting electrode 43 has a shape in which sawtooth-like dips and bumps are repeated regularly along its entire length, the zigzag pattern is not limited thereto. Preferably, the wiring members 12 are directly bonded to the metal layer 42 via the adhesive 16 in at least part of the periphery of the respective projecting electrodes 43, which may be portions between the repeating dips and bumps.

As described above, in the photovoltaic device 11, the metal layer 42 is laminated over a large area on the rear surface side of the photoelectric conversion unit 20 (or the n-type amorphous silicon layer 25). With this configuration, light that has entered through the light receiving surface and transmitted through the photoelectric conversion unit 20 can be reflected by the metal layer 42 toward the light receiving surface side. By laminating the metal layer 42 on the photoelectric conversion unit 20 with the transparent conductive layer 41 disposed therebetween, in one example, light absorption due to generation of evanescent light is minimized, thereby achieving higher reflectance. As a result, the ratio of light utilization in the photoelectric conversion unit 20 is increased, and photoelectric conversion efficiency becomes enhanced.

Via the transparent conductive layer 41, it is possible to suppress diffusion of metal atoms constituting the metal layer 42 into the photoelectric conversion unit 20, so that generation of defect level that traps carriers can be minimized.

The metal layer 42 is formed thinner than the light receiving surface electrode 30. Furthermore, the metal layer 42 is formed thin so as to include surface unevenness reflecting the textured structure. With this configuration, the difference between the amount of metal material used for the light receiving surface electrode 30 and that used for the metal layer 42 is reduced, so that deflection of the photoelectric conversion unit 20 is suppressed. As a result, the thickness of the projecting electrodes 43 can be made small. Further, since the projecting electrodes 43 are formed on the metal layer 42, the projecting electrodes 43 are not subjected to limitation in thickness by the finger electrode portions 32 as are the bus bar electrode portions 33. For example, the thickness of the projecting electrodes 43 can be within the range from a value greater than or equal to the surface unevenness height (T) of the metal layer 42 to a value less than the thickness of the light receiving surface electrode 20.

As a result of the above-described achieved effects, photoelectric conversion efficiency can be enhanced in the photovoltaic device 11 of the present embodiments. Further, using the photovoltaic devices 11, a highly reliable module can be constructed.

In the photovoltaic module 10 constructed from the photovoltaic devices 11, since the projecting electrodes 43 have a small thickness, the adhesive 16 extends over and beyond the thickness of the projecting electrodes 43 and reaches the metal layer 42. In other words, the adhesive 16 extends continuously from the side surface of each wiring member 12 to the metal layer 42, and the wiring members 12 are directly bonded to the metal layer 42 via the adhesive 16. As a result, the bonding area between the rear surface electrode 40 and the wiring members 12 is enlarged. With this configuration, the wiring members 12 can be prevented from peeling off of the rear surface electrode 40, and reliability of the photovoltaic module 10 can be enhanced.

More specifically, by bonding the wiring members 12 directly to the metal layer 42 via the adhesive 16, it is possible to suppress movement of the wiring members 12 in the width direction, thickness (depth) direction, and length direction. In other words, the strength of the wiring members 12 in movement directions (hereinafter referred to as "shear force") is increased. For example, by configuring such that a wiring member 12 is directly bonded to the metal layer 42 via the adhesive 16 along its entire length on both sides of a projecting electrode 43 in the width direction, the shear force of the wiring member 12 in the width and thickness direction is increased. Further, by configuring such that the wiring member 12 is directly bonded to the metal layer 42 via the adhesive 16 in the entire periphery of the projecting electrode 43, the shear force of the wiring member 12 in the width, thickness, and length directions is increased.

While the above embodiments refer, as an example, to the photoelectric conversion unit 20 having a structure in which amorphous silicon layers are laminated on both surfaces of the n-type monocrystalline silicon substrate 21, the structure of the photoelectric conversion unit is not limited thereto. For example, the photoelectric conversion unit may have a structure in which the i-type amorphous silicon layer 24 and the n-type amorphous silicon layer 25 are not provided, or a structure that uses a semiconductor other than silicon (such as gallium arsenide). Further, while it is described that, in the above embodiments, the side on which the p-type amorphous silicon layer 23 is provided corresponds to the light receiving surface side, it is alternatively possible to provide the light receiving surface electrode 30 on the n-type amorphous silicon layer 25, so that the side on which the n-type amorphous silicon layer 25 is provided serves as the light receiving surface side.

While the above description refers to various example shapes of the projecting electrodes 43, the bus bar electrode portions 33 can also be formed in various shapes, similar to the projecting electrodes 43.

### LIST OF REFERENCE NUMERALS

10 photovoltaic module; 11 photovoltaic device; 12 wiring member; 13 first protective member; 14 second protective member; 15 sealant; 16 adhesive; 20 photoelectric conversion unit; 21 n-type monocrystalline silicon substrate; 22, 24 i-type amorphous silicon layer; 23 p-type amorphous silicon layer; 25 n-type amorphous silicon layer; 30 light receiving surface electrode; 31, 41 transparent conductive layer; 32 finger electrode portion; 33 bus bar electrode portion; 40 rear surface electrode; 42 metal layer; 43 projecting electrode.

## Claims

1. A photovoltaic device, comprising:
a photoelectric conversion unit having a light receiving surface and a rear surface each having a textured structure formed thereon;
a light receiving surface electrode provided on the light receiving surface of the photoelectric conversion unit; and
a rear surface electrode provided on the rear surface of the photoelectric conversion unit,
wherein the rear surface electrode includes:
a transparent conductive layer laminated on the rear surface of the photoelectric conversion unit;
a metal layer laminated over substantially an entire surface of the transparent conductive layer and having surface unevenness reflecting the textured structure; and
a projecting electrode formed on the metal layer and having a thickness larger than a surface unevenness height of the metal layer.

2. The photovoltaic device according to claim 1, wherein
the projecting electrode is formed to have a thickness smaller than a thickness of the light receiving surface electrode.

3. The photovoltaic device according to claim 1 or 2, wherein
the metal layer is laminated over the entire surface of the transparent conductive layer.

4. The photovoltaic device according to any one of claims 1 to 3, wherein
reflectance of the metal layer is higher than reflectance of the transparent conductive layer at least with respect to light in an infrared region having a wavelength in a range of 800 nm to 1200 nm.

5. The photovoltaic device according to any one of claims 1 to 3, wherein
the metal layer is a film containing at least Ag.

6. The photovoltaic device according to any one of claims 1 to 5, wherein the photoelectric conversion unit comprises:
a crystalline semiconductor substrate; and
a amorphous semiconductor layer laminated on a rear surface of the crystalline semiconductor substrate,
wherein the transparent conductive layer is laminated on the rear surface of the amorphous semiconductor layer.

7. A photovoltaic module, comprising:
a photovoltaic device; and
a wiring member electrically connected to the photovoltaic device,
wherein the photovoltaic device comprises:
a photoelectric conversion unit;
a light receiving surface electrode provided on a light receiving surface of the photoelectric conversion unit; and
a rear surface electrode including a transparent conductive layer laminated on a rear surface of the photoelectric conversion unit, a metal layer laminated over substantially an entire surface of the transparent conductive layer, and a projecting electrode formed on the metal layer, and
wherein the wiring member is electrically connected to the projecting electrode via an adhesive, and is also directly bonded to the metal layer via the adhesive in at least part of a periphery of the projecting electrode.

8. The photovoltaic module according to claim 7, wherein
the wiring member has the adhesive adhered to its side surface, and the side surface and the metal layer are directly bonded to each other via the adhesive.

9. The photovoltaic module according to claim 7 or 8, wherein
the metal layer is laminated over the entire surface of the transparent conductive layer.

10. The photovoltaic module according to any one of claims 7 to 9, wherein
the light receiving surface and the rear surface of the photoelectric conversion unit each have a textured structure formed thereon, and the metal layer is formed thin so as to include surface unevenness reflecting the textured structure, and
the thickness of the projecting electrode is within a range from a value greater than or equal to a surface unevenness height of the metal layer to a value less than a thickness of the light receiving surface electrode.

11. The photovoltaic module according to any one of claims 7 to 10, wherein
the wiring member is directly bonded to the metal layer via the adhesive on at least one side, in a width direction, of the projecting electrode.

12. The photovoltaic module according to claims 11, wherein
the wiring member is directly bonded to the metal layer via the adhesive on both sides, in the width direction, of the projecting electrode.

13. The photovoltaic module according claim 11 or 12, wherein
the wiring member is wider than the projecting electrode, and the wiring member and the projecting electrode are connected to each other while the wiring member is in a state of being protruded from at least one side, in the width direction, of the projecting electrode.

14. The photovoltaic module according to any one of claims 7 to 10, wherein
the wiring member is directly bonded to the metal layer via the adhesive in an entire periphery of the projecting electrode disposed on the metal layer.

15. The photovoltaic module according to any one of claims 7 to 10, wherein
the projecting electrode is provided in a number of two or more, and the plurality of projecting electrodes are arranged in an array while being spaced apart from each other, and
the wiring member is directly bonded to the metal layer via the adhesive in at least a gap between adjacent projecting electrodes.

16. The photovoltaic module according to any one of claims 7 to 15, wherein
reflectance of the metal layer is higher than reflectance of the transparent conductive layer at least with respect to light in an infrared region having a wavelength in a range from 800 nm to 1200 nm.

17. The photovoltaic module according to any one of claims 7 to 16, wherein
the metal layer is a film containing at least Ag.

18. The photovoltaic module according to any one of claims 7 to 17, wherein the photoelectric conversion unit comprises:
a crystalline semiconductor substrate; and
a amorphous semiconductor layer laminated on a rear surface of the crystalline semiconductor substrate,
wherein the transparent conductive layer is laminated on the rear surface of the amorphous semiconductor layer.
